# EUROPÄISCHE PATENTSCHRIFT

(11) **EP 1 019 945 B1**
(45) Veröffentlichungstag und Bekanntmachung des Hinweises auf die Patenterteilung: **06.04.2005**
(21) Anmeldenummer: 98947538.9
(22) Anmeldetag: 18.09.1998
(51) Int. Cl.: H01J 37/32, C23C 16/54

(54) **VERFAHREN UND VORRICHTUNG ZUR OBERFLÄCHENBEHANDLUNG VON SUBSTRATEN**
METHOD AND DEVICE FOR SURFACE-TREATING SUBSTRATES
PROCEDE ET DISPOSITIF POUR LE TRAITEMENT SUPERFICIEL DE SUBSTRATS

(30) Priorität: 06.10.1997 DE 19744060
(43) Veröffentlichungstag der Anmeldung: 19.07.2000
(73) Patentinhaber: Fraunhofer-Gesellschaft zur Förderung der angewandten Forschung e.V., 80686 München (DE)
(72) Erfinder: JUNG, Thomas, D-38173 Hötzum (DE); KLAGES, Claus-Peter, D-38102 Braunschweig (DE)
(74) Vertreter: Pfenning, Meinig & Partner GbR
(86) Internationale Anmeldenummer: PCT/EP1998/005982
(87) Internationale Veröffentlichungsnummer: WO 1999/018593

(56) Entgegenhaltungen:
- EP-A- 0 879 897
- DD-A5- 294 511
- JP-A- 63 026 373
- US-A- 4 637 853
- US-A- 5 595 792
- PATENT ABSTRACTS OF JAPAN vol. 015, no. 436 (C-0882), 7. November 1991 & JP 03 183782 A (MATSUSHITA ELECTRIC IND CO LTD), 9. August 1991

## Beschreibung

Die Erfindung betrifft ein Verfahren und eine Vorrichtung zur Oberflächenbehandlung von Substraten mit Hilfe einer Gasentladung.

Bei der Oberflächenbehandlung ebener Substrate mittels Gasentladungen wie Niederdruck-Glimmentladungen sind Verfahren bekannt, bei denen die Entladung durch eine Mikrowellenantenne, durch eine Hochfrequenz-Elektrode oder durch eine an das Substrat angelegte gepulste oder zeitlich konstante Gleichspannung aufrechterhalten wird. Substratoberfläche und Gegenelektrode bzw. Mikrowellenantenne sind dabei meist gegenüberliegend angeordnet.

Ein entscheidender Nachteil dieser Verfahren ist, daß in der Regel nur eine geringe Plasmadichte erzeugt werden kann und die Geschwindigkeit einer Plasmareinigung oder Plasmabeschichtung der Substratoberfläche daher niedrig ist. Zwar läßt sich durch Druckerhöhung auch die Plasmadichte erhöhen, die damit verbundene Abnahme der mittleren freien Weglänge führt jedoch dazu, daß der Materialtransport zur und von der Substratoberfläche stark behindert wird. Außerdem wächst die Neigung der Entladung zur lokalen Kontraktion und Instabilität. Nachteilig bei diesen Verfahren ist außerdem, daß es zu einer unerwünschten Beschichtung des Mikrowellen-Einkopplungsfensters bzw. der Hochfrequenz-Elektrode kommt, wodurch die eingekoppelte Leistung mit der Zeit deutlich abnimmt.

Nachteilig ist weiterhin, daß große Mengen an Ausgangsstoffen dadurch verlorengehen, daß außer dem Substrat auch alle anderen inneren Oberflächen der Vakuumkammer beschichtet werden. Dies erfordert zudem eine häufige und daüberhinaus aufwendige Reinigung der Anlage.

Die Oberflächenbehandlung von laufenden Metallbändern, etwa Stahl- oder Aluminiumblech, aktiviert oder unterstützt durch eine elektrische Gasentladung, wirft gegenüber der Behandlung von Substraten im Batch-Verfahren besondere Probleme auf.

Zum einen erfordert die hohe Bandlaufgeschwindigkeit, bei Stahlblechen in der Größenordnung von bis zu 100 m/min, sehr hohe stationäre Beschichtungsraten und Plasmadichten. Um beispielsweise eine Schichtdicke von 100 nm abzuscheiden, ist bei einer Bandgeschwindigkeit von 100 m/min und einer Beschichtungszonenlänge von 1 m eine stationäre Beschichtungsrate von 10 µm/min erforderlich. Dies sind rund 2 Größenordnungen mehr, als mit gewöhnlichen Gleich- oder Wechselstromglimmentladungen erreichbar sind.

Außer zur Erzielung hoher Abscheideraten sind auch für effektive Abtragsraten von Oberflächenkontaminationen (Ölen, Fetten, Wachsen) unter Bildung von gasförmigen Produkten auf einem schnell laufenden Band möglichst hohe Plasmadichten anzustreben. Gewöhnliche Glimmentladungen besitzen im allgemeinen keinen hinreichenden Ionisationsgrad und einen zu geringen Anteil an aktiven Spezies wie Sauerstoff-Atomen oder Hydroxylradikalen.

Neben der Bereitstellung hoher Plasmadichten wird von derartigen Produktionsanlagen erwartet, daß sie mehrere Tage ohne Wartung betrieben werden können. Voraussetzung hierfür ist, daß die parasitäre Abscheidung von Schichten, d.h. das Aufwachsen von Schichten an anderen Orten als auf dem zu behandelnden Blech, gering gehalten wird. Es ist zu bedenken, daß in 100 Stunden die hypothetische "stationäre" Schichtdicke auf einem ruhenden Blech bei einer Aufwachsrate won 10 µm/min bis zu 6 cm betragen würde. Auch wenn die parasitäre Aufwachsrate auf einer Gegenelektrode oder auf einem Abschirmblech oder der Gehäusewand nur 1% dieses Wertes betragen würde, wären die resultierenden Schichten von 600 µm Schichtdicke unakzeptabel, da sie infolge innerer Spannungen nicht mehr auf ihrer Unterlagen haften und in Form von abgeplatzten Flittern den Beschichtungsprozeß stören würden.

Die EP 0 879 897 A1 ist die Offenlegungsschrift einer Patentanmeldung, die eine Priorität vor der Priorität der vorliegenden Erfindung in Anspruch nimmt, jedoch veröffentlicht wurde, nachdem die vorliegende Erfindung angemeldet wurde. Sie ist daher relevant bezüglich Neuheit der vorliegenden Erfindung. Diese Druckschrift beschreibt nun die Behandlung eines bandförmigen Substrates, das einen Entladungsbereich auf einer Seite begrenzt. Die andere Seite des Entladungsbereiches wird durch eine Gegenelektrode begrenzt. Durch Führung des bandförmigen Substrates im Zickzack kann auch das Substrat selbst eine Hohlkathode bilden. Diese Druckschrift enthält jedoch keine Offenbarung bezüglich des Abstandes zwischen den eine Hohlkathode bildenden Seiten des im Zickzack geführten Bandes.

Die JP 63 026 373 A mit zugehörigem Abstract offenbart die innenseitige Beschichtung einer Röhre, in dem die Innenseiten der Röhre zur Erzeugung einer Hohlkathodenentladung verwendet werden. Die Röhrenwandung begrenzt dabei den Entladungsbereich.

Die DD 29 45 11 A5 offenbart die Innenbeschichtung eines Rohres, wobei eine Quelle bestehend aus Gaseinspeisung, Anode und Hohlkathode in das zu beschichtende Rohr eingeschoben wird. In dieser Druckschrift wird der Entladungsbereich nicht nur durch das zu beschichtende Rohr selbst begrenzt.

Die US 4 637 853 A offenbart ebenfalls die Behandlung von Substraten durch eine Hohlkathodenentladung. Die Substrate werden hierzu in eine Hohlkathode eingebracht.

Der vorliegenden Erfindung liegt die Aufgabe zugrunde, ein Verfahren und eine Vorrichtung zur Oberflächenbehandlung von Substraten zu schaffen, die neben hohen Plasmadichten auch eine Konzentration der hohen Plasmadichten in unmittelbarer Nähe der zu behandelnden Oberfläche bei gleichzeitiger Reduzierung parasitärer Abscheidungen gewährleisten. Dabei soll sowohl eine Beschichtung von fortlaufend geförderten, z.B. bandförmigen, Substraten möglich sein.

Diese Aufgabe wird in verfahrenstechnischer Hinsicht durch Anspruch 1 und, was eine Vorrichtung zur Durchführung des Verfahrens angeht, durch Anspruch 15 gelöst. Die jeweiligen Unteransprüche geben vorteilhafte Ausgestaltungen und Weiterbildungen der Erfindung an.

Indem die zu behandelnden Oberflächen eines oder mehrerer, elektrisch leitender oder leitfähig beschichteter Substrate auf wenigstens zwei Seiten die elektrische Gasentladung mit einem Abstand zwischen 1 mm und 10 cm räumlich begrenzen, läßt sich in unmittelbarer Nähe der Substratoberflächen ein konzentriertes Plasma hoher Plasmadichte realisieren. Das mindestens eine Substrat bildet dabei eine Hohlkathode. Durch die lokale Begrenzung der Entladung werden parasitäre Effekte an nicht zu behandelnden Oberflächen stark reduziert. Bei der Entladung handelt es sich bevorzugt um eine Glimmentladung.

Die Begrenzung des Entladungsbereiches findet auf mindestens zwei, im wesentlichen gegenüberliegenden Seiten statt. Der Einschluß erfolgt durch mindestens ein fortlaufend gefördertes Substrat. Unabhängig von der Form des Einschlusses beträgt der Abstand von jeweils gegenüberliegenden Substratoberflächen ungefähr 1 mm bis 10 cm, bevorzugt 1 cm bis 10 cm.

Das erfindungsgemäße Verfahren ist besonders geeignet zur Behandlung kontinuierlich geförderter Substrate, beispielsweise bandförmiger Materialien. Dabei wird der Entladungsbereich dadurch begrenzt, daß z.B. ein oder mehrere Substratbänder zumindest bereichsweise in geringem gegenseitigem Abstand eine stationäre Gasentladung passieren und dadurch den Entladungsbereich begrenzen. So können beispielsweise zwei Bänder bereichsweise parallel zueinander geführt werden und die stationäre Gasentladung von jeweils einer zu behandelnden Oberfläche jedes Bandes eingeschlossen werden.

Besonders bevorzugt ist die Oberflächenbehandlung von einem oder mehreren bandförmigen Substraten, welche unter Änderung ihrer Förderrichtung mindestens einmal umgelenkt werden und den Entladungsbereich zumindest zum einen durch einen Oberflächenbereich, der in Bandlaufrichtung vor der Umlenkung liegt, und zum anderen durch einen Oberflächenbereich, der in Bandlaufrichtung nach der Umlenkung liegt, begrenzen. Auf diese Weise passiert die zu behandelnde Oberfläche des bandförmigen Substrates die Entladungszone je nach Bandführung mindestens zweimal. Die damit einhergehende intensivierte Oberflächenbehandlung gestattet vorteilhafterweise eine Erhöhung der Fördergeschwindigkeit.

Bei der elektrischen Entladung handelt es sich um eine Entladung im Bereich der Hohlkathodenentladung. Darunter wird erfindungsgemäß auch noch eine Entladung im Übergangsbereich zwischen Hohlkathodenentladung und normaler Entladung verstanden. Das gesamte Substrat, das auf Erdpotential liegen kann, bildet dabei die Kathode. Eine Anode, die gegenüber Erde auf einem positiven Potential liegt, befindet sich als Gegenelektrode an einer geeignet gewählten Stelle in der Apparatur, vorzugsweise am Rand der Gasentladung. Auch bei einer durch Mikrowellen aktivierten Entladung kann sich eine Hohlkathodenentladung ausbilden. Das Plasma bildet dann eine "virtuelle" Anode.

Eine Hohlkathodenentladung ist wesentlich intensiver als eine gewöhnliche Glimmentladung zwischen parallel angeordneter Kathode und Anode. Es wird eine um Größenordnungen höhere Ionisation erreicht und dementsprechend lassen sich auch wesentlich höhere Beschichtungs- bzw. Abtragsraten erzielen. Die Hohlkathodenentladung bildet sich bei Verwendung einer Gleich- oder Wechselspannung dann aus, wenn die Substratoberflächen den Entladungsbereich hohlraumförmig, d.h. auf mindestens zwei Seiten, eingrenzen und in Abhängigkeit von der Substratgeometrie bzw. der Geometrie des Entladungsbereiches geeignete Verfahrensparameter (Druck, Abstand der Substratoberflächen, Spannung, usw.) gewählt werden. Eine Hohlkathodenentladung zwischen z.B. zwei bandförmigen Substraten manifestiert sich in einem deutlich höheren Entladungsstrom im Vergleich zur Summe der Ströme bei je einer getrennten Entladung an jeder der beiden Substrate.

Eine elektrische Entladung läßt sich außer durch eine Gleich- oder Wechselspannung auch durch Einkopplung von Mikrowellen in den Entladungsbereich realisieren.

Dazu sollte der durch die Substratoberfläche definierte Entladungsbereich eine Geometrie aufweisen, welche die Ausbreitung der Mikrowellen in bestimmten Raumbereichen und die Entstehung einer Gasentladung durch die Erzielung hoher elektrischer Felder begünstigt. Bevorzugt weist der Entladungsbereich dazu eine Hohlraumgeometrie auf, wobei die Hohlraumdimensionen der Wellenlänge der verwendeten Mikrowellenstrahlung angepaßt sind. Als Weiterbildung ist denkbar, in den Entladungsbereich gleichzeitig Mikrowellen und eine elektrische Spannung, bevorzugt eine Gleichspannung, einzuspeisen.

Die Gaszu- und Gasabführung erfolgt bevorzugt direkt im Entladungsbereich oder unwesentlich davon beabstandet. Durch geeignete Anordnung der Gaszu- und Gasabführung läßt sich die Entladung unmittelbar auf den vorgesehenen Entladungsbereich zwischen den Substratoberflächen beschränken und parasitäre Entladungen stark reduzieren. Bevorzugt sind die Mittel zur Gaszu- und Gasabführung auf gegenüberliegenden Seiten des Entladungsbereiches angeordnet, so daß eine ständige Strömung aufrechterhalten werden kann.

Weitere Vorteile und Weiterbildungen der Erfindung ergeben sich aus den Figuren und den nachfolgend beschriebenen Ausführungsbeispielen. Es zeigen:
- Figur 1:: die Durchführung des erfindungsgemäßen Verfahrens bei Verwendung eines fortlaufend geförderten, bandförmigen Substrates;
- Figur 2:: die Durchführung des erfindungsgemäßen Verfahrens bei Verwendung zweier fortlaufend geförderter, bandförmiger Substrate;
- Figur 3:: die Durchführung des erfindungsgemäßen Verfahrens bei Verwendung eines fortlaufend geförderten, bandförmigen Substrates, das von einem Abschirmelement umgeben ist.

Bei dem in den Figuren dargestellten Substraten 1 handelt es sich um 0,15 mm starkes und 50 Zentimeter breites, bandförmiges und kontinuierlich gefördertes Aluminiumblech. Andere Substrate, beispielsweise Stähle oder leitfähig beschichte Materialien, lassen sich ebenso behandeln.

Bei zu starker Aufheizung kann das behandelte Substrat 1 während der Oberflächenbehandlung gekühlt werden. Die Kühlung kann durch einen Kühlkörper, der von einem flüssigen oder gasförmigen Kühlmedium durchströmt wird und in direktem mechanischen Kontakt zum Substrat steht, erfolgen. Bei stationären Substraten bietet sich die Kühlung mittels Kühlplatten und bei bewegten Substraten mittels Kühlwalzen an.

Das Substrat 1 kann geerdet oder mit dem nicht geerdeten Ausgang einer Spannungsquelle verbunden sein. Bevorzugt liegt die Spannung zwischen Substrat und einem aufgrund der elektrischen Entladung gebildeten Plasma zwischen 1 und 3000 Volt, besonders bevorzugt zwischen 100 und 1000 Volt. Als Gleichspannungen kommen auch gepulste Gleichspannungen mit einer Pulsfrequenz zwischen 10 kHz und 100 kHz in Frage. Bei Verwendung von niederfrequenten Wechselspannungen liegt die Frequenz bevorzugt zwischen 50 und 60 Hz und bei mittelfrequenten Wechselspannungen bevorzugt zwischen 10 und 100 kHz. Hochfrequente Wechselspannungen weisen bevorzugt Frequenzen zwischen 1 und 50 MHz auf. Anstatt oder zusätzlich zur Einspeisung mit einer Spannungsquelle läßt sich elektrische Energie auch durch Mikrowellen einspeisen. Die Mikrowellenfrequenzen liegen bevorzugt im GHz-Bereich.

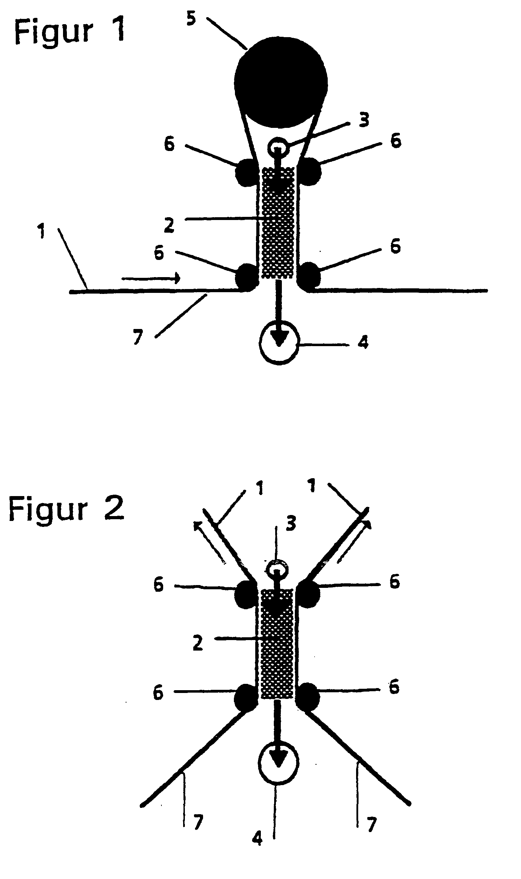

Die gesamten in den Figuren 1 bis 3 dargestellten Anordnungen sind, ggf. zusammen mit den Spulen zur Auf- und Abwicklung des Bandes bzw. der Bänder, in nicht dargestellten Vakuumkammern untergebracht. Bei Verwendung von bandförmigen Substraten kann das Substrat auch über außerhalb der Vakuumkammer angeordnete Spulen und Vakuumschleusen zum und aus dem Entladungsbereich 2 gefördert werden. Die Entladung läuft bevorzugt bei einem Druck zwischen 0,01 mbar und 100 mbar, besonders bevorzugt zwischen 0,1 und 5 mbar, ab.

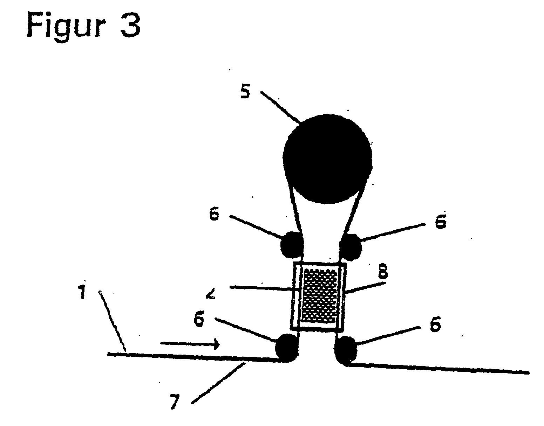

Über die Gaszuführungen 3 (in Figur 3 nicht dargestellt) werden Inertgase wie Argon, reaktive Gase oder auch Gasgemische in die Vakuumkammer eingeführt. Als reaktive Gase kommen zum Beispiel oxidierende, reduzierende, kohlenstoffhaltige oder siliziumhaltige Gase wie Sauerstoff, Wasserstoff, Stickstoff, Methan, Ethin, Silan, Hexamethyldisiloxan, Tetramethylsilan, usw. in Frage. Mit Hilfe der reaktiven Gase können zum Beispiel Schichten aufgetragen, Material abgetragen oder in die Oberflächenbereiche Gasbestandteile integriert werden. So lassen sich Substratoberflächen von Verunreinigungen wie Schmierstoffen, Korrosionsschutzmitteln oder Oxydschichten reinigen oder mit Korrosionsschutzschichten, Haftschichten für nachfolgende Beschichtungen, Gleitschichten zur Verbesserung der Umformeigenschaften oder dekorativen Schichten versehen.

Die Gasabführungen 4 (in Figur 3 nicht dargestellt) aus der Vakuumkammer gewährleisten, daß depositionsfähige oder abtragungsfähige Produkte aus der Entladungszone abgeführt werden, ohne Gelegenheit zur parasitären Ablagerung oder Abtragung zu bekommen.

Eine weitere Möglichkeit zur Reduzierung der parasitären Effekte besteht in der Anordnung von Abschirmelementen, beispielsweise Blechen, in der Vakuumkammer. Diese Abschirmelemente sind, von den Vorrichtungskomponenten und dem Substrat elektrisch isoliert, in denjenigen Bereichen der Vakuumkammer (Kammerwänden, Flansche, etc.) angeordnet, wo sich aufgrund des vorhandenen Potentials parasitäre Entladungen ausbilden könnten oder umschließen Entladungsbereich und Substrat. In Figur 3 ist ein derartiges Abschirmelement in Form eines Blechkäfigs 8 dargestellt.

Schließlich gestatten weitere, von Vorrichtungskomponenten und Substraten elektrisch isolierte Abschirmelemente auch ein Verschließen derjenigen Seiten des Entladungsbereiches, welche nicht durch Substratoberflächen begrenzt sind. Verbleibende Spalte zwischen diesen Abschirmelementen und den Substraten können mit einem isolierenden Stoff (Oxidkeramik, wärmebeständiger Kunststoff) verschlossen werden. Hierdurch wird gewährleistet, daß nur noch eine geringe Anzahl an Ladungsträgern aus dem Hohlraum des Entladungsbereiches entweichen kann.

Nachfolgend werden die geometrischen Dimensionen der in den Figuren 1, 2 und 3 dargestellten Vorrichtung erläutert. Der Durchmesser der oberen dicken Umlenkrolle 5 (Figuren 1 und 3) beträgt 50 cm und der Durchmesser der vier unteren, im Rechteck angeordneten Rollen 6 beträgt 16 cm. Der horizontale Abstand der Achsen der unteren Rollen 6 beträgt 19 cm und der vertikale Abstand der Achsen der unteren Rollen 6 beträgt 30 cm. Es entsteht ein für die Ausbildung einer Hohlkathoden-Glimmentladung besonders günstiges Volumen von etwa 30 x 50 x 3 cm zwischen Teilen des Aluminiumbleches.

Die Gaszufuhr 3 erfolgt gemäß Figur 1 und 2 durch ein mit 50, je 0,7 mm großen Löchern versehenes Edelstahlrohr von 1 cm Durchmesser. Dieses Edelstahlrohr ist parallel zu den Achsen der kleinen Rollen 6 angeordnet. Die Gasabführung 4 erfolgt durch ein ebenfalls mit Löchern versehenes Edelstahlrohr unterhalb des unteren Rollenpaares. Das Edelstahlrohr für die Gasabführung 4 weist 100 Löcher mit 2 mm Durchmesser auf. Das Abpumpen des Gases geschieht mittels einer Roots-Pumpe, die ein effektives Saugvermögen von 500 m³/h aufweist.

In den Figuren 1, 2 und 3 ist das geförderte Blech 1 elektrisch vom Gehäuse isoliert und geerdet. Als Gegenelektrode (Anode) dient das Gaszuführungsrohr. Als Spannungsquelle kann entweder eine Gleichspannungsquelle (10 bis 1000 V) oder eine mittelfrequente Spannungsquelle (35 kHz, 500 V Spitzenspannung) verwendet werden. Alternativ kann die Hohlkathodenentladung durch die Einspeisung von Mikrowellen aktiviert werden.

### Ausführungsbeispiel 1: Reinigung

Das einlaufende Blech 1 wird über einen Schwamm mit Paraffinöl benetzt (ungefähr 0,5 g/m²). Die Bandlaufgeschwindigkeit beträgt 10 m/min und der Druck 0,5 mbar. Als Gas wird künstliche Luft (ein Sauerstoff/Stickstoffgemisch im Verhältnis 1:4) mit einem Volumenstrom von 4,5 m³/h verwendet. Bei einer Gleichspannung von 450 Volt bildet sich zwischen den Blechen eine intensive Entladung aus. Nach dem Durchgang durch die Entladungszone besitzt das Blech auf der zu behandelnden Seite 7 eine Oberflächenenergie von 55 · 10⁻³ N/m (55 dyn/cm) (Bestimmung mit Testtinten). Dies belegt, daß das Öl vollständig abgetragen wurde.

### Ausführungsbeispiel 2: Plasmapolymerisation

Bei diesem Beispiel beträgt die Bandlaufgeschwindigkeit 20 m/min und der Druck ebenfalls 0,5 mbar. Als Gas wird ein Gemisch aus Argon und HMDSO (Hexamethyldisiloxan) im Partialdruckverhältnis 10:1 und bei einem Gesamtvolumenstrom von 70 mbar x 1 /s (4,2 slm) verwendet. Bei Anlegen einer mittelfrequenten Spannung (500 Volt) bildet sich zwischen den Blechen eine Hohlkathodenentladung aus. Auf der Blechoberfläche 7 wird eine Plasmapolymerschicht von 53 nm Dicke abgeschieden. Die dynamische Rate (Produkt von Bandgeschwindigkeit und Schichtdicke) dieser Anordnung beträgt ungefähr 1060 m x nm / min. Auf einem ruhenden Blech würde die Depositionsgeschwindigkeit damit etwa 30 nm/s betragen.

### Ausführungsbeispiel 3: Silikatisierung

Anstelle von Argon im Beispiel 2 wird künstliche Luft bei einem Volumenstrom von 60 mbar x l/s verwendet. Die Bandgeschwindigkeit beträgt 30 m/min. Es bildet sich eine Siliziumoxydschicht von 30 nm Dicke aus. Die dynamische Rate beträgt 600 m x nm/min, die statische Rate 17 nm/s. Die Zusammensetzung der Schicht (lt. EPMA): SiO_{1,7}C_{0,2}- Die Oberflächenenergie (Testtinten) beträgt über 58 · 10⁻³ N/m (58 dyn/cm).

## Patentansprüche

1. Verfahren zur Oberflächenbehandlung von mindestens einem, elektrisch leitenden oder leitfähig beschichteten Substrat (1) mit Hilfe eines im Bereich einer elektrischen Entladung angeordneten Gases, wobei
der Entladungsbereich (2) durch zu behandelnde Substratoberflächen (7) zumindest auf zwei gegenüberliegenden Seiten begrenzt wird und
das mindestens eine Substrat (1) eine Hohlkathode bildet,
**dadurch gekennzeichnet, dass** der Entladungsbereich zumindest bereichsweise auf den zwei gegenüberliegenden Seiten begrenzt wird durch ein oder mehrere, fortlaufend geförderte Substrate (1), wobei die zwei Seiten einen Abstand von 1 mm bis 10 cm voneinander aufweisen.

2. Verfahren nach Anspruch 1, **dadurch gekennzeichnet, dass** die Substratoberflächen (7) durch eine Hohlkathodenentladung behandelt werden.

3. Verfahren nach einem der Ansprüche 1 oder 2, **dadurch gekennzeichnet, dass** bandförmige Substrate behandelt werden.

4. Verfahren nach Anspruch 3, **dadurch gekennzeichnet, dass** das mindestens eine geförderte Substrat (1) zur Änderung der Förderrichtung mindestens einmal umgelenkt wird und der Entladungsbereich (2) auf mindestens einer Seite durch in Förderrichtung vor der mindestens einen Umlenkung (5) und auf mindestens einer weiteren Seite durch in Förderrichtung nach der mindestens einen Umlenkung (5) liegende Substratbereiche begrenzt wird.

5. Verfahren nach einem der Ansprüche 1 bis 4, **dadurch gekennzeichnet, dass** die elektrische Entladung bei einem Druck zwischen 0,01 mbar bis 100 mbar abläuft.

6. Verfahren nach einem der Ansprüche 1 bis 5, **dadurch gekennzeichnet, dass** das mindestens eine Substrat (1) geerdet wird.

7. Verfahren nach einem der Ansprüche 1 bis 6, **dadurch gekennzeichnet, dass** die Spannung zwischen dem mindestens einen Substrat (1) und einem aufgrund der elektrische Entladung ausgebildeten Plasma 1 bis 3000 V beträgt.

8. Verfahren nach einem der Ansprüche 1 bis 7, **dadurch gekennzeichnet, dass** die Entladung durch Mikrowellen aktiviert oder unterstützt wird.

9. Verfahren nach einem der Ansprüche 1 bis 8, **dadurch gekennzeichnet, dass** die Entladung durch eine Gleichspannung, eine gepulste Gleichspannung oder durch eine nieder-, mittel- oder hochfrequente Wechselspannung aktiviert oder unterstützt wird.

10. Verfahren nach einem der Ansprüche 1 bis 9, **dadurch gekennzeichnet, dass** die Zuführung des Gases im Entladungsbereich (2) oder unmittelbar außerhalb davon erfolgt.

11. Verfahren nach einem der Ansprüche 1 bis 10, **dadurch gekennzeichnet, dass** die Abführung des Gases im Entladungsbereich (2) oder unmittelbar außerhalb davon erfolgt.

12. Verfahren nach einem der vorhergehenden Ansprüche, **dadurch gekennzeichnet, dass** als Gas ein oxidierendes, reduzierendes, kohlenstoffhaltiges und/oder siliziumhaltiges Gas verwendet wird.

13. Verfahren nach einem der vorhergehenden Ansprüche, **dadurch gekennzeichnet, dass** als Gas ein Gas verwendet wird, das Sauerstoff, Wasserstoff, Stickstoff, Methan, Ethin, Silan, Hexamethylsiloxan und/oder Tetramethylsiloxan enthält.

14. Verfahren nach einem der vorhergehenden Ansprüche, **dadurch gekennzeichnet, dass** das Gas durch den Entladungsbereich hindurchströmt.

15. Vorrichtung zur Durchführung des Verfahrens nach einem der Ansprüche 1 bis 14 mit :
mindestens einem Substrat (1), das einen auf mindestens zwei gegenüberliegenden Seiten von Substratoberflächen (7) umschlossenen Entladungsbereich (2) definiert und eine Hohlkathode bildet,
einer Vorrichtung zur Einspeisung elektrischer Energie in den Entladungsbereich,
einer den Entladungsbereich umgebende Vakuumkammer,
einer Gaszuführung (3) in die Vakuumkammer, einer Gasabführung (4) aus der Vakuumkammer und
einer im Bereich des Substrates (1) angeordneten Anode, **dadurch gekennzeichnet, dass**
der Entladungsbereich zumindest bereichsweise auf den zwei gegenüberliegenden Seiten begrenzt wird durch ein oder mehrere, fortlaufend geförderte Substrate (1), wobei die zwei Seiten einen Abstand von 1 mm bis 10 cm voneinander aufweisen.

16. Vorrichtung nach Anspruch 15, **dadurch gekennzeichnet, dass** eine Substratkühlung vorgesehen ist.

17. Vorrichtung nach einem der Ansprüche 15 oder 16, **dadurch gekennzeichnet, dass** die Gaszuführung (3) im Entladungsbereich (2) oder unmittelbar außerhalb davon angeordnet ist.

18. Vorrichtung nach einem der Ansprüche 15 bis 17, **dadurch gekennzeichnet, dass** die Gasabführung (4) im Entladungsbereich (2) oder unmittelbar außerhalb davon angeordnet ist.

19. Vorrichtung nach einem der Ansprüche 15 bis 18, **dadurch gekennzeichnet, dass** das mindestens eine Substrat (1) ein fortlaufend gefördertes Band ist, das von einer ersten Spule abwickelbar und auf einer zweiten Spule aufwickelbar ist.

20. Vorrichtung nach Anspruch 19, **dadurch gekennzeichnet, dass** die Spulen außerhalb der Vakuumkammer angeordnet sind und das Band über Vakuumschleusen in die Vakuumkammer einführbar und ausführbar ist.

21. Vorrichtung nach Anspruch 19, **dadurch gekennzeichnet, dass** die Spulen innerhalb der Vakuumkammer angeordnet sind.

22. Vorrichtung nach einem der Ansprüche 15 bis 21, **dadurch gekennzeichnet, dass** in der Vakuumkammer im Bereich der nicht von Substratoberflächen (7) begrenzten Seiten des Entladungsbereichs (2) Abschirmelemente angeordnet sind und diese Abschirmelemente von dem mindestens einen Substrat (1) elektrisch isoliert sind.

23. Vorrichtung nach einem der Ansprüche 15 bis 22, **dadurch gekennzeichnet, dass** in der Vakuumkammer in Bereichen von Vorrichtungskomponenten, in denen sich aufgrund ihres Potentiales parasitäre Entladungen ausbilden können, oder um Substrat (1) und Entladungsbereich (2) Abschirmelemente angeordnet sind und diese Abschirmelemente von den Vorrichtungskomponenten und dem Substrat (1) elektrisch isoliert sind.

24. Verwendung eines Verfahrens und/oder einer Vorrichtung nach einem der vorhergehenden Ansprüche, zur Reinigung einer Oberfläche.

25. Verwendung nach dem vorhergehenden Anspruch, zur Abtragung von Schmierstoffen, Korrosionsschutzmitteln oder Oxidschichten von der Oberfläche.

26. Verwendung eines Verfahrens und/oder einer Vorrichtung nach einem der Ansprüche 1 bis 23, zur Beschichtung einer Oberfläche.

27. Verwendung nach dem vorhergehenden Anspruch, zur Beschichtung der Oberfläche mit einer Korrosionsschutzschicht, einer Haftschicht, einer Gleitschicht, einer dekorativen Schicht.

28. Verwendung nach einem der beiden vorhergehenden Ansprüche, zur Beschichtung der Oberfläche mit einer Plasmapolymerschicht oder Siliziumoxidschicht.

29. Verwendung eines Verfahrens und/oder einer Vorrichtung nach einem der Ansprüche 1 bis 23, zur Integration von Gasbestandteilen in die Oberfläche des Substrates (1).

30. Verwendung nach einem der Ansprüche 24 bis 29, zur Behandlung von Aluminiumblech oder Stahlblech.

## Claims

1. Method for surface treatment of at least one electrically conductive or conductively coated substrate (1) by means of a gas located within the area of an electrical discharge, whereby the discharge area (2) is limited on at least two opposing sides by the substrate surfaces (7) to be treated, and whereby at least one substrate (1) forms a hollow cathode, **characterised in that** the discharge area is limited at least in part by one or several continuously conveyed substrates (1) on the two opposing sides, whereby the two sides are located at a distance of 1mm to 10cm from one another.

2. Method according to Claim 1, **characterised in that** the substrate surfaces (7) are treated by means of a hollow cathode discharge.

3. Method according to one of the Claims 1 or 2, **characterised in that** strip-shaped substrates are treated.

4. Method according to Claim 3, **characterised in that** the at least one conveyed substrate (1) is diverted at least once to change the direction of conveyance, and **in that** the discharge area (2) is limited on at least one side by the substrate areas located prior to the at least one diversion (5) in the direction of conveyance, and on at least one further side after a diversion (5) in the direction of conveyance.

5. Method according to one of the Claims 1 to 4, **characterised in that** the electrical discharge occurs at a pressure of between 0.01 mbar and 100 mbar.

6. Method according to one of the Claims 1 to 5, **characterised in that** the at least one substrate (1) is earthed.

7. Method according to one of the Claims 1 to 6, **characterised in that** the voltage between the at least one substrate (1) and a plasma formed by means of the electrical discharge is 1 to 3000 volt.

8. Method according to one of the Claims 1 to 7, **characterised in that** the discharge is activated or supported by means of microwaves.

9. Method according to one of the Claims 1 to 8, **characterised in that** the discharge is activated or supported by means of a direct current, a pulsed direct current, or by means of a low, medium, or high frequency alternating current.

10. Method according to one of the Claims 1 to 9, **characterised in that** the supply of gas occurs within the discharge area (2) or immediately outside of the same.

11. Method according to one of the Claims 1 to 10, **characterised in that** the venting of the gas occurs within the discharge area (2) or immediately outside of the same.

12. Method according to one of the preceding Claims, **characterised in that** an oxidised, reducing, carbon containing and/or silicone containing gas is used as the gas.

13. Method according to one of the preceding Claims, **characterised in that** a gas containing oxygen, hydrogen, nitrogen, methane, ethine, silane, hexamethylsiloxane and/or tetramethylsiloxane is used as the gas.

14. Method according to one of the preceding Claims, **characterised in that** the gas flows through the discharge area.

15. Means for carrying out the method according to one of the Claims 1 to 14 ,with:
at least one substrate (1) defining a discharge area (2) enclosed by substrate surfaces (7) on at least two opposing sides, and forming a hollow cathode,
a means for the supply of electrical energy to the discharge area,
a vacuum chamber surrounding the discharge area,
a gas supply (3) into the vacuum chamber, a gas outlet (4) from the vacuum chamber, and
an anode located within the area of the substrate (1),
**characterised in that** the discharge area is limited at least in part on the two opposing sides by one or several, continuously conveyed substrates (1), whereby the two sides are located at a distance of 1mm to 10cm from one another.

16. Means according to Claim 15, **characterised in that** substrate cooling is envisaged.

17. Means according to one of the Claims 15 or 16, **characterised in that** the gas supply (3) is located within the discharge area (2) or immediately outside of the same.

18. Means according to one of the Claims 15 to 17, **characterised in that** the gas outlet (4) is located within the discharge area (2) or immediately outside of the same.

19. Means according to one of the Claims 15 to 18, **characterised in that** the at least one substrate (1) consists of a continuously conveyed strip which is dispensed from a first coil, and which can be wound onto a second coil.

20. Means according to Claim 19, **characterised in that** the oils are located outside of the vacuum chamber, and **in that** the strip can be fed into and out of the vacuum chamber by means of vacuum locks.

21. Means according to Claim 19, **characterised in that** the coils are located within the vacuum chamber.

22. Means according to one of the Claims 15 to 21, **characterised in that** shielding elements are located within the vacuum chamber within the area of the sides of the discharge area (2) that are not limited by the substrate surfaces (7), and **in that** these shielding elements are electrically isolated from the at least one substrate (1).

23. Means according to one of the Claims 15 to 22, **characterised in that** shielding elements are located within the vacuum chamber within the areas of the means components in which parasitic discharges can form due to their potential, or around the substrate (1) and the discharge area (2), and **in that** these shielding elements are electrically isolated from the means components and the substrate (1).

24. Use of a method and/or a means according to one of the preceding Claims for the cleaning of a surface.

25. Use according to the preceding Claim for the removal of layers of grease, corrosion protection medium, or oxidation from a surface.

26. Use of a method and/or a means according to one of the Claims 1 to 23 for the coating of a surface.

27. Use according to the preceding Claim for the coating of a surface with a corrosion protection layer, an adhesive layer, a glide layer, a decorative layer.

28. Use according to one of the preceding Claims for the coating of a surface with a plasma polymer layer or silicone oxide layer.

29. Use of a method and/or a means according to one of the Claims 1 to 23 for the integration of gas components into the surface of the substrate (1).

30. Use according to one of the Claims 24 to 29 for the treatment of aluminium sheet metal or steel sheet metal.

## Revendications

1. Procédé pour le traitement de surface d'au moins un substrat (1) portant un revêtement électroconducteur ou conducteur, à l'aide d'un gaz disposé dans une zone de décharge électrique,
la zone de décharge (2) étant limitée au moins sur deux côtés opposés par les surfaces (7) du substrat à traiter et
le au moins un substrat (1) formant une cathode creuse,
**caractérisé en ce que** la zone de décharge est limitée au moins partiellement sur les deux côtés opposés par un ou plusieurs substrats (1) amenés en continu, les deux côtés présentant un espacement de 1 mm à 10 cm l'un par rapport à l'autre.

2. Procédé selon la revendication 1, **caractérisé en ce que** les surfaces (7) du substrat sont traitées par une décharge à cathode creuse.

3. Procédé selon une des revendications 1 ou 2, **caractérisé en ce que** des substrats en forme de bande sont traités.

4. Procédé selon la revendication 3, **caractérisé en ce que** le au moins un substrat (1) amené est dévié au moins une fois pour modifier le sens de transport, et **en ce que** la zone de décharge (2) est limitée sur au moins un côté par une zone du substrat se trouvant avant la au moins une déviation (5) dans le sens du transport, et sur au moins un autre côté par une zone du substrat se trouvant après la au moins une déviation (5) dans le sens du transport.

5. Procédé selon une des revendications 1 à 4, **caractérisé en ce que** la décharge électrique se produit à une pression de 0,01 mbar à 100 mbar.

6. Procédé selon une des revendications 1 à 5, **caractérisé en ce que** le au moins un substrat (1) est mis à la masse.

7. Procédé selon une des revendications 1 à 6, **caractérisé en ce que** la tension entre le au moins un substrat (1) et un plasma formé en raison de la décharge électrique est de 1 à 3 000 V.

8. Procédé selon une des revendications 1 à 7, **caractérisé en ce que** la décharge est activée ou soutenue par micro-ondes.

9. Procédé selon une des revendications 1 à 8, **caractérisé en ce que** la décharge est activée ou soutenue par une tension continue, une tension continue pulsée ou par une tension alternative basse, moyenne ou haute fréquence.

10. Procédé selon une des revendications 1 à 9, **caractérisé en ce que** l'alimentation en gaz se produit dans la zone de décharge (2) ou immédiatement à l'extérieur de cette dernière.

11. Procédé selon une des revendications 1 à 10, **caractérisé en ce que** l'évacuation du gaz se produit dans la zone de décharge (2) ou immédiatement à l'extérieur de cette dernière.

12. Procédé selon une des revendications précédentes, **caractérisé en ce que** le gaz utilisé est un gaz oxydant, réducteur, contenant du carbone et/ou contenant du silicium.

13. Procédé selon une des revendications précédentes, **caractérisé en ce que** le gaz utilisé est un gaz qui contient de oxygène, de l'hydrogène, de l'azote, du méthane, de l'acétylène, du silane, de l'hexaméthyle siloxane et/ou du tétra méthyle siloxane.

14. Procédé selon une des revendications précédentes, **caractérisé en ce que** le gaz s'écoule en traversant la zone de décharge.

15. Dispositif pour la mise en oeuvre du procédé selon une des revendications 1 à 14, comprenant :
au moins un substrat (1) qui définit une zone de décharge (2) fermée sur au moins deux côtés opposés par des surfaces (7) du substrat et forme une cathode creuse,
un dispositif pour l'accumulation de l'énergie électrique dans la zone de décharge,
une chambre à vide entourant la zone de décharge,
une alimentation en gaz (3) de la chambre à vide, un évacuation du gaz (4) hors de la chambre à vide et une anode disposée dans la zone du substrat (1), **caractérisé en ce que** la zone de décharge est limitée au moins partiellement sur les deux côtés opposés par un ou plusieurs substrats (1) amenés en continu, les deux côtés présentant un espacement de 1 mm à 10 cm l'un par rapport à l'autre.

16. Dispositif selon la revendication 15, **caractérisé en ce qu'**il est prévu un refroidissement du substrat.

17. Dispositif selon la revendication 15 à 17, **caractérisé en ce que** l'alimentation en gaz (3) est disposée dans la zone de décharge (2) ou immédiatement à l'extérieur de cette dernière.

18. Dispositif selon la revendication 15 ou 16, **caractérisé en ce que** l'évacuation du gaz (4) est disposée dans la zone de décharge (2) ou immédiatement à l'extérieur de cette dernière.

19. Dispositif selon une des revendications 15 à 18, **caractérisé en ce que** le au moins un substrat (1) est une bande transportée en continu, qui peut être dévidée d'une première bobine et enroulée sur une deuxième bobine.

20. Dispositif selon la revendication 19, **caractérisé en ce que** les bobines sont disposées hors de la chambre à vide et **en ce que** la bande peut être introduite dans et extraite de la chambre à vide par transfert sous vide.

21. Dispositif selon la revendication 19, **caractérisé en ce que** les bobines sont disposées à l'intérieur de la chambre à vide.

22. Dispositif selon une des revendication 15 à 21, **caractérisé en ce que** des éléments de protection sont disposés dans la chambre à vide, dans la région des côtés de la zone de décharge (2) non limités par les surfaces (7) du substrat, et **en ce que** ces éléments de protection sont isolées du au moins un substrat (1).

23. Dispositif selon une des revendication 15 à 22, **caractérisé en ce que** des éléments de protection sont disposés dans la chambre à vide, dans les régions des composants du dispositifs dans lesquelles des décharges parasitaires peuvent se former en raison de leur potentiel, ou autour du substrat (1) et de la zone de décharge (2), et **en ce que** ces éléments de protection sont isolés électriquement des composants du dispositif et du substrat (1).

24. Utilisation d'un procédé et/ou d'un dispositif selon une des revendications précédentes pour le nettoyage d'une surface.

25. Utilisation selon la revendication précédente pour l'enlèvement de lubrifiants, d'agents anticorrosion et de couches d'oxyde de la surface.

26. Utilisation d'un procédé et/ou d'un dispositif selon une des revendications 1 à 23 pour le revêtement d'une surface.

27. Utilisation selon la revendication précédente pour le revêtement de la surface avec une couche de protection contre la corrosion, une couche adhésive, une couche antifriction, une couche décorative.

28. Utilisation selon une des deux revendications précédentes pour le revêtement de la surface avec une couche de plasma-polymère ou une couche d'oxyde de silicium.

29. Utilisation d'un procédé et/ou d'un dispositif selon une des revendications 1 à 23 pour l'intégration de composants gazeux dans la surface du substrat (1).

30. Utilisation selon une des revendications 24 à 29 pour le traitement de tôle d'aluminium ou de tôle d'acier.
